Europäisches Patentamt

(19) European Patent Office

Office européen des brevets

(11) Publication number: **0 004 751**
A2

## (12) EUROPEAN PATENT APPLICATION

(21) Application number: **79300520.8**

(22) Date of filing: **29.03.79**

(51) Int. Cl.²: **H 05 B 7/00**
**H 05 H 1/26, H 01 J 37/32**

(30) Priority: **08.04.78 GB 1386178**

(43) Date of publication of application:
**17.10.79 Bulletin 79/21**

(84) Designated Contracting States:
**CH DE FR GB**

(71) Applicant: **Laporte Industries Limited**
**Hanover House 14 Hanover Square**
**London W1R 0BE(GB)**

(72) Inventor: **Robinson, Michael**
**Pink Cottage Ulceby Road**
**Wooton South Humberside(GB)**

(74) Representative: **Ffrench-Lynch, Cecil et al,**
**Group Patents Department Laporte Industries Limited P**
**O Box 8**
**Luton Bedfordshire Lu4 8EW(GB)**

(54) **Electrical discharge heating device and method of heating using such.**

(57) In an expanded electrical discharge heater (1) a moveable discharge source is provided with a drive linkage comprising two separately but simultaneously operable linkages, each of which may be a crank (4) motivated arm (5), each linkage being capable of applying a reciprocating movement to the discharge source at an angle to that applied by the other linkage. By control of the frequency ratio and phase shift between the reciprocating movements complex path patterns of the discharge source may be achieved thereby enabling wear to be more evenly distributed about the discharge source and the heater interior. A high proportion of the cross-section of the heating chamber (14) may be traversed (15) giving the possibility of an increase in the effective capacity of the heating chamber and of a lengthened residence time in the heating chamber.

Fig. 1.

Croydon Printing Company Ltd.

- 1 -

ELECTRICAL DISCHARGE HEATING DEVICE

The present invention relates to an electrical discharge heating device.

An electrical discharge device may be used to heat material, including particulate solid material, by a method according to which the material is introduced into, or into the vicinity of, the discharge. A plasma heater is particularly useful for heating particulate solid material since it has a relatively lower tendency, than some other types of electrical discharge heating device, to exhibit discharge instability in the presence of the material. By "plasma heater" we mean a heater incorporating an electrical discharge device by means of which a flow of gas may be heated to form a hot gaseous stream by contact with which stream a material may be heated.

British Patents No. 1390351, 1390352 and 1390353 relate to the construction and use of a plasma heater. It is proposed in these patents to cause a moveable discharge source to strike a discharge with a stationary annular electrode and to move around a closed circular path within an enclosed zone at a speed sufficent to maintain expansion of the discharge in at least a major part of the space lying between the path of said source and said stationary electrode and to feed said particulate material into the upper part of said space. Depending on whether the axis of the moveable discharge source is parallel to the axis of the stationary annular electrode or angled to it, either a substantially cylindrical or a substantially truncated conically shaped expanded discharge may be obtained. The particular method of putting the invention into effect which is described in these patents is to mount the moveable discharge source in a rotor capable of rotating in a plane at right angles to the axis of the stationary electrode and to drive the rotor through a chain drive by means of an electric motor.

We understand the term "expansion" used in relation to an electrical discharge to mean an effect whereby, due to movement of the discharge, it is caused to give the effect of occupying a larger volume than it would normally occupy.

The electrical discharge heater disclosed in British Patent Nos. 1390351, 1390352 and 1390353 is disclosed to be of advantage in many respects and to be usable in the treatment of a wide variety of particulate materials. It is disclosed, for example, to treat comminuted ores by a variety of high temperature processes such as calcining, roasting or smelting. Particular advantages adduced are the lengthening of the residence time of particles in the heater by offering a spiral as the line of descent of the particles, a high capacity due to the capability to entrain large quantities of particles, efficient heat transfer, freedom from electron scavenging effects and versatility with respect to the nature and voltage of the electrical supply.

The present invention is directed to the provision of a new or improved electrical discharge heating device and provides a means for moving a discharge source, for the purpose of achieving expansion of the discharge, comprising two separately but simultaneously operable linkages each being capable of applying a reciprocating movement to the moveable discharge source at an angle to that applied by the other linkage.

- 3 -

Due to the mutual effect of the two linkages the resulting actual movement of the discharge source, as will be described hereinafter, is other than reciprocating.

The present invention particularly provides an electrical discharge heating device comprising a chamber defining a heating zone, a moveable electrical discharge source arranged to effect, in use, an expanded electrical discharge in the heating zone, and at least one source of motive power connected to the moveable discharge source characterised in that the means of connection of the at least one source of motive power to the moveable discharge source comprises two linkages each being separately capable of applying a reciprocating movement to the discharge source, the reciprocating movements lying at an angle to each other and the linkages also being arranged to operate simultaneously.

The linkages may be simple rod linkages.

Depending on the angle between the linkages and on the relative frequencies and amplitudes of reciprocating movements which may be applied by the linkages the moveable discharge source may, in operation, be caused to follow an extremely complex path which is reflected by the movement of the discharge about the heating zone of the device and the overall shape and size of an expanded discharge so achieved. Wear due to the discharge can be more evenly distributed about the interior of the apparatus and, especially, about the moveable discharge source itself, resulting in a longer apparatus life. Such a path may be selected to traverse a high proportion of the cross-section of the chamber defining the heating zone giving the possibility for a still further increase in capacity of the chamber for particles to be heated in comparison with the heating device described in British Patents No. 1390351, 1390352, 1390353. The invention

- 4 -

also gives the possibility to achieve a high residence time in the heating zone.

The angle between the reciprocating movements may determine the overall shape of the expanded discharge the more acute the angle the more elongated the discharge shape. Preferably, unless a heating zone having an elongated cross-section is in use, the movements are approximately at right angles to each other and, suitably, do not deviate from right angles by more than $20^{o}$ and, particularly preferably, by more than $10^{o}$. The word "angle" above and hereafter is taken to exclude $0^{o}$ and $180^{o}$.

The amplitude of the reciprocating movement which may, in operation, be applied to the moveable discharge source will determine the cross-sectional size of the expanded discharge and this size is therefore, suitably, preferably tailored to the cross-sectional size of the heating zone by suitable selection of the linkage amplitude.

For a given angle between the reciprocating movements and for a given amplitude thereof the path pattern of the moveable discharge source may be selected by the control of the ratio of the frequency of the movements and by the phase shift between the movements and it is readily possible to select either a relatively simple or an extremely complex path by such control. One set of examples of repeating path patterns which may be selected using integral frequency ratios are represented by Lissajous Figures as illustrated, for example, in the Norstrand Technical Encyclopaedia Ed.5 page 1101. Due to the repeating nature of path patterns corresponding to Lissajous Figures the use of such path patterns does not completely eliminate the element of uneven apparatus wear. Preferably, therefore, the relationships between the movement of the linkages are selected to be non-integral and so as to give a progressive or otherwise

- 5 -

non-repeating path which will eventually traverse substantially the whole space within the overall boundary of the path pattern thereby giving optimum wear evenness. Preferably the path pattern repeats itself less frequently than every 10, particularly preferably than every 100, reciprocating movements of each linkage.

Suitably the moveable discharge source is located relative to the chamber by a mounting adapted to allow pivotal movement under the influence of the movement of the linkages. Such a mounting may be a ball joint. The two linkages may be arranged to act on the side of the pivot point external to the chamber. This arrangement enables the amplitude of movement of the linkages to be smaller than the desired maximum dimensions of the space occupied by the discharge within the chamber. This is desirable since it reduces mechanical stress on the apparatus.

The moveable discharge source usually comprises an electrode together with a supporting structure. It may be considered to have a longitudinal axis generally transverse to a discharge surface and extending away from the heating zone. For example, where two linkages are employed and the moveable discharge source is located relative to the chamber by a mounting allowing pivotal movement thereof, the longitudinal axis of the moveable discharge source may be considered to pass through the pivot point. It is convenient to consider the spatial arrangement of the linkages with reference to the point on the longitudinal axis, or an extension thereof outwardly from the chamber, on which they may be considered to have effect.

According to a further aspect of the present invention the means of connection of at least one source of motive power to the moveable discharge source may also comprise a further two linkages each being separately capable of applying a reciprocating movement to the discharge source

the reciprocating movements lying at an angle to each other the further linkages also being arranged to operate simultaneously the first linkages being arranged to operate in concert with the further linkages but at a different effective point or points on the moveable discharge source therefrom.

Hereafter we refer to the linkages first above referred to and claimed in claim 1 hereafter as "the first linkages", where required to distinguish them from "the further linakges".

Where the means of connection of the at least one source of motive power to the moveable discharge source consists of the first linkages there is no constraint that the linkages should have a common effective point on the moveable discharge source although such is preferred since a separation of the effective points of the two linkages can cause complications arising from their different distances from the mounting locating the discharge source relative to the chamber.

Where the means of connection of the at least one source of motive power to the moveable discharge source includes the further linkages certain constraints apply if all of the linkages are to be enabled to act, in concert, without interfering with each other. For example one possible arrangement of the first linkages and the further linkages could be for them to be so arranged that the movements of each one of the first and of the further linkages, are at right angles to each other and the movement of each one of the first linkages is parallel to that of a different one of the further linkages. Such an arrangement would allow all the linkages to act even if all four linages had separated effective points on the discharge source. Preferably, however, the first linkages and the further linkages, each have a common effective point said common points being separated. The angle between the movements

- 7 -

of the further linkages is preferably approximately at right angles and suitably does not deviate from a right angle by more than $20^\circ$ and particularly preferably by more than $10^\circ$. Preferably the movement of each of the first linkages lies parallel to that of a different one of the further linkages.

In the case where the further linkages are employed pivotal motion of the moveable discharge source may be achieved by the first linkages and the further linkages being arranged to have a different amplitude of movement. Preferably each of the first linkages is arranged to reciprocate at the same frequency as, and in synchronization with, a different one of the further linkages.

Where further linkages are employed the movement of the discharge source precludes the use of a fixed pivotal mounting of the moveable discharge source relative to the chamber. Suitably in this case the moveable discharge source is located relative to the chamber by a mounting allowing a limited degree of transverse movement in any direction in a single plane together with pivotal motion thereof. Such an arrangement has the advantage that it may allow the mounting means to be located distant from the heating chamber and, thereby, to be less affected by distortion or other mechanical problems due to excessive heat. Suitably the mounting allowing limited transverse movement in a single plane comprises a plate member connected to the moveable discharge source, the plate member being supported on a bearing member, for example , a planar bearing pad or plate, the plate member supporting the moveable discharge source being allowed to slide within limits over the surface of the bearing member in any direction under the influence of the movement of the linkages.

An alternative mounting for the moveable source may comprise suitable supports for the linkages. For example the linkages may be rods passing through supported sleeves

- 8 -

or rings which allow limited angular movement of the rods by, for example, being themselves mounted so as to allow limited rotation in a horizontal plane.

It is desirable to restrict rotational movement of the moveable discharge source about its own axis. This may be achieved by means of a member attached to the moveable discharge source together with restraining means for the member. The member may be, for example, a rod the free end of which may be restrained from all but limited angular movement by means of, for example, a suitable gate member.

The means for restricting rotational movement of the moveable discharge source about its own axis may be utilised as a part of the mounting means for the moveable discharge source. For example, the member arranged to restrict such rotational movement may pass through a member providing a fulcrum and on the side of the fulcrum distant from the moveable discharge source bear a suitable plate member arranged to coact with a suitable bearing member or means, there being allowed a limited transverse movement of the plate member on the bearing member. In this case accompanying pivotal motion of the moveable discharge source may be allowed for by means of a suitable connection allowing such motion between the member restricting the rotational movement of the moveable discharge source and the moveable discharge source itself.

The moveable discharge source may require cooling by suitable heat exchange means such as, for example, the supply thereto and the removal therefrom of a suitable heat exchange fluid which may be, for example, water. If the moveable discharge source is a plasma source there will be required a suitable supply of gas for example an inert gas, for plasma formation. Suitably the moveable discharge source is supplied by means of flexible leads and or piping with an electrical supply, with heat exchange means and with any necessary gas for plasma formation.

Suitably the source of motive power for the moveable electrical discharge source comprises one or more electric motors. A single motor may be used provided that it is provided with separate gearing for each linkage. Preferably a separate electric motor is used to drive each first or further linkage. Particularly preferably each further linkage is driven by the same electric motor as a corresponding one of the first linkages. A simple means of converting the movement of the electric motors into reciprocating movement of a linkage is to connect the linkages to the motor by means of a rotatable, preferably counterbalanced, crank or eccentric. This expedient is preferred since it results in a harmonic motion of the linkage which is of itself desirable since it tends to reduce mechanical stress. Due to the motion of the crank there will be a slight angular deviation of the linkage from a strictly reciprocating movement. A reference to a reciprocating movement does not exclude a movement including such a deviation. Where reference is made herein to the movements of linkages being in parallel this includes such like deviations from the true parallel. Each rod linkage may be connected to the crank or eccentric at one end and to the moveable discharge source at the other end by means allowing at least some relative movement to enable the changes of the relative position of the moving parts of the apparatus, which occurs in practice, to be accommodated.

Certain desirable path patterns are achievable only by the impression of more than one reciprocating, motion on each linkage. This is preferably achieved by using eccentric mountings for the cranks.

The present invention is preferably utilised in relation to an electrical discharge heating device incorporating a moveable electrical discharge source, a cylindrical

- 10 -

heating zone enclosed by walls, a stationary electrode spaced across the heating zone from the plasma source, and means for feeding particulate solid material into the heating zone.

The stationary electrode must be effective throughout the movement of the discharge source. Preferably, therefore, the stationary electrode comprises a recovery vessel constructed of electrically conductive material such as graphite, into which the heated solids fall when they cease to be entrained in the heating zone, the whole of the recovery vessel constituting the stationary electrode. This is particularly effective where metaliferous ore is the particulate solids feed into the heating zone and wherein, in the course of heating, the metal content of the ore or of a portion of it, is converted to the metallic state. The resulting accumulation of metal in the recovery vessel, if electrically conductive, can provide the stationary electrode. In an embodiment of this kind where electrically conductive material is produced in the course of the heating, the collecting vessel need not be a particularly good conductor. Many normally non-electrically conducting materials become conductive at the temperatures normally prevailing in electrical discharge heating devices and such a material may provide a suitable collecting vessel provided that suitable electrical connections and a means of start-up, to enable the temperature to be built up, are provided for.

Very suitably the present invention may be used in relation to the heating of a particulate titaniferous iron-containing ore or ore derivative such as rutile, ilmenite, or a synthetic rutile, in the presence of carbon to convert at least a part of the iron therein to the metallic state.

One form of apparatus according to the invention is more particularly described hereafter

- 11 -

with reference to the accompanying drawings.

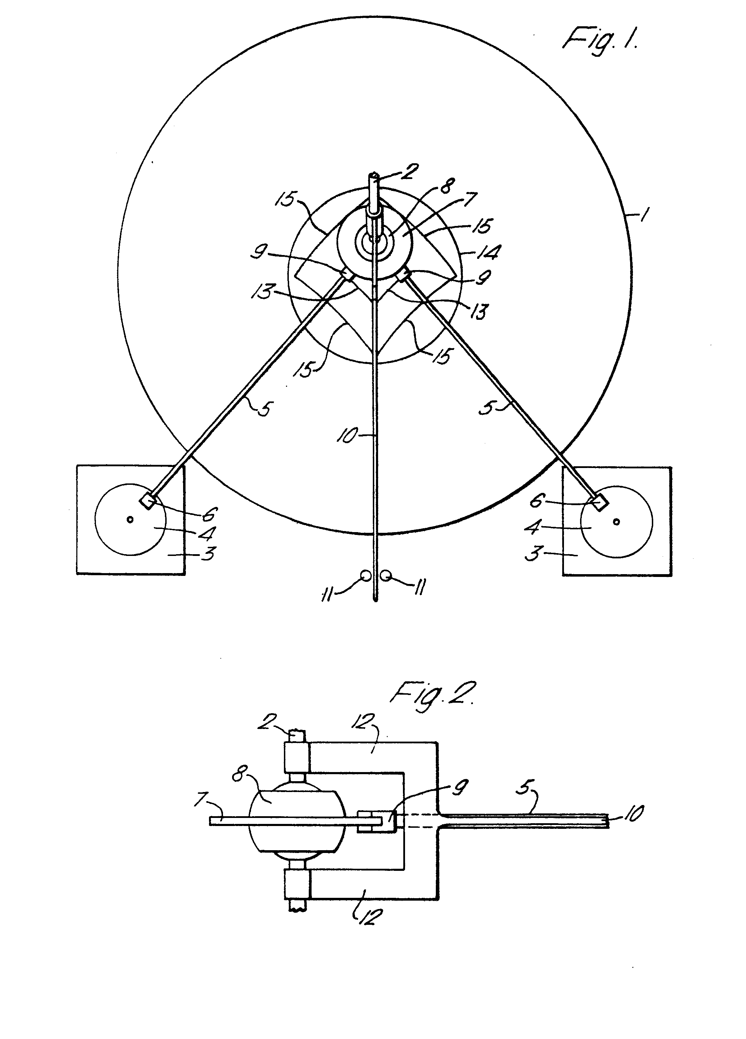

Figure 1 comprises a plan view and part section of the top of an electrical discharge heating device incorporating a moveable electrical discharge source and two linkages.

Figure 2 is an elevational view of a part of a linkage of the electrical discharge heater omitting a view of the linkage lying nearest the eye.

The electrical discharge heating device comprises a generally cylindrical heating chamber having a thick surrounding wall comprising an inner refractory layer, a thermally insulating layer and a casing. The heating device is shown generally as 1. Pivotably attached to the top of the heating chamber there is a moveable electrical discharge source 2.

Apparatus associated with the application of the invention to the heating device 1 comprises the electric motors 3, desirably connected to the counterbalanced eccentrics 4, and the rod linkages 5 attached at one end to the eccentrics 4 by means of the universal joints 6 and at the other end to the discharge source 2. The rod linkages are mounted horizontally when the discharge source is positioned vertically. The means whereby the rod linkages 4 are connected to the moveable discharge source 2 comprises a circular plate 7 mounted about the moveable discharge source by means of a ball joint 8 and the universal joints 9 attached to the edge of the plate 7.

Means to restrict rotational movement of the discharge source 2 about its own axis comprises a rod 10 fixed to the discharge source at one end and restrained at the other end from angular movement, other than the minimum associated with the alteration in position of the point of attachment of the rod 10 to the discharge source 2 by virtue of the pivotal movement of the discharge source relative to the heating chamber 1, by vertical parallel circular section rods 11 which allows both vertical movement of the rod 10 and limited horizontal movement thereof. The rod 10 is connected to the discharge source 2 by a U piece 12 the legs of which are clamped about the discharge source 2 and lies radially with respect to the ball joint 8.

In the practice of the invention the motors 3 are set in motion and due to the effect of the eccentrics each connecting rod 5 is set in motion. Due to the combined effect of the motion of the drive rods the discharge source is caused to pivot within limits which, with reference to the centre point of the ball valve, are defined by the length of the connecting rods 5 and the throw of the eccentrics 4. In the embodiment illustrated, where the connecting rods and the throws of the eccentrics are equal the limits of movement of the said centre point lie within an approximately square area with slightly curved edges of which two sides are visible and denoted by 13. Although not visible the circumference of the heating chamber is shown as 14. Due to the depth of the chamber and the pivotal mounting of the discharge source 2 the discharge within the chamber may be expanded, by the movement of the discharge source, to cover an area of the same shape as that bounded by the centre point of the bearing 8, but larger, and this area is indicated by boundary lines 15.

In one embodiment of the invention in the form above illustrated the heating chamber has a diameter of 16 inches and a depth from the discharge point of 18 inches, and the overall diameter of the device may be 48 inches. The connecting rods 5 are tubes having a diameter of 12 inches and a wall thickness of 3/16 inches and are 36 inches long. The eccentrics 4 each have a 4 inch throw and are driven by ¼ horsepower electric motors equipped with independent speed controls and a speed indicating/ recording/ controlling device each, in turn, fitted with

- 13 -

a ratio relay feeding a speed ratio indicating/recording/ controlling device.  The angle between the notional lines from the rotational point of the eccentrics 4 to the pivot point of the discharge source 2 is 90°.

In one example of the operation of the embodiment last above described the ratio between the speeds of the cranks 4 is 3.03 to 2.00, the electrical discharge is initiated and the speed increased from zerc to up to 500 rpm on the faster motor on start up, and an optimum speed setting searched fcr with respect to the other furnace variables, e.g. voltage devloped and feed rates of furnace load given.  When such optimum speed on the faster motor is found, it is locked on and the appropriate speed on the other motor locked on with the speed ratio controller being used in cascade control to maintain the speed ratio against accidental fluctuation.

If desired the speed ratio may be set at 7.05:3 or 5.05:2 or any other speed ratio which departs slightly from a simple integral setting and which gives regular coverage of the target area as understood by those versed in the art.

Suitably the speed ratio departs from a simple integral ratio (expressed by the product of dividing the larger integer by the smaller integer) by from 0.4% tc 5.0% and, for example, to obtain a reasonable path pattern progression, from 0.5 to 3.5%.  The speed level is suitably from about 300 revolutions per minutes upwards and may, for example, be from about 400 revolutions per minutes to about 2000 revolutions per minutes to obtain reasonable discharge expansion without undue mechanical stress.

0004751

What we claim is

1. An electrical discharge heating device comprising a chamber defining a heating zone, a moveable electrical discharge source arranged to effect, in use, an expanded electrical discharge in the heating zone and at least one source of motive power connected to the moveable discharge source characterised in that the means of connection of the at least one source of motive power to the moveable discharge source comprises a first two linkages each being separately capable of applying a reciprocating movement to the discharge source, the reciprocating movements lying at an angle to each other, and the linkages also being arranged to operate simultaneously.

2. A device as claimed in claim 1 wherein the means of connection of the at least one source of motive power to the moveable discharge source comprises a further two linkages each being separately capable of applying a reciprocating movement to the discharge source, the reciprocating movements lying at an angle to each other the further linkages also being arranged to operate simultaneously, the first linkages being arranged to operate in concert with the further linkages but at a different effective point or points on the moveable discharge source therefrom.

3. A device as claimed in claim 2 wherein the first linkages and the further linkages are so arranged that the movement of each one of the first linkages lies parallel to that of a different one of the further linkages.

4. A device as claimed in claim 2 or 3 wherein the first linkages and the further linkages are arranged to have a different amplitude of movement from each other.

5. A device as claimed in claim 2,3 or 4 wherein the first linkages and the further linkages, are each arranged to operate at a single effective point.

6. A device as claimed in claim 1 wherein the means of connection of the at least one source of motive power to the moveable discharge source consists of two linkages and the moveable discharge source is located relative to the chamber by a mounting adapted to allow pivotal movement under the influence of the movement of the linkages.

7. A device as claimed in claim 6 wherein the mounting is a ball joint.

8. A device as claimed in any one of claims 2-5 wherein the moveable discharge source is located, relative to the chamber, by a mounting allowing limited transverse movement in any direction in one plane, and also pivotal movement thereof, under the influence of the movement of the linkages.

9. A device as claimed in claim 8 wherein the mounting is a plate, which is arranged to move within limits in one plane in combination with a separate mounting adapted to allow pivotal movement.

10. A device as claimed in any one of claims 1 to 9 wherein each linkage is a crank motivated rod linkage.

11. A device as claimed in claim 10 wherein the axes of some or all of the cranks are themselves eccentrically mounted.

12. A device as claimed in any preceding claim where one of the first linkages and/or of the further linkages is arranged to apply a reciprocating movement to the discharge source at an angle of from 70° to 110° to the other one of the first linkages and/or of the

further linkages respectively.

13. A device as claimed in any preceding claim wherein each first or further linkage is powered by a separate electric motor.

14. A device as claimed in any preceding claim including a stationary discharge receptor comprising a vessel constructed of an electrically conductive material.

15. A device as claimed in any one of claims 1 to 13 including a stationary discharge receptor comprising a vessel arranged, in use, to contain electrically conductive material.

16. A method of heating a material comprising treating the material to be heated in an electrical discharge heating device as claimed in any preceding claim.

17. A method as claimed in claim 16 wherein the material is a particulate iron-containing material and wherein said material is treated in the electrical discharge heating device to convert at least a part of the iron content thereof into the metallic state.

18. A method as claimed in claim 16 or 17 wherein one of the linkages and/or of the further linkages is caused to reciprocate at a frequency which has a non-integral relationship with the other of the linkages and/or of the further linkages respectively.

19. A method as claimed in claim 16 or 17 wherein each of the first linkages is caused to reciprocate at the same frequency as and in syncronisation with a different one of the further linkages.

20. A method as claimed in claim 18 or 19 wherein the said relationship varies from the integral by from 0.4% to 5.0%.

21. A method as claimed in any one of claims 16 to 20 wherein the frequency of reciprocation is at least 300 per minute.

22. The product of a method as claimed in any one of claims 16 to 21.

0004751

Fig. 1.

Fig. 2.